# EUROPEAN PATENT APPLICATION

(11) **EP 1 471 631 A1**
(43) Date of publication of application: **27.10.2004**
(21) Application number: 04009311.4
(22) Date of filing: 20.04.2004
(51) Int. Cl.: H03B 5/18

(54) **Transistor oscillator**

(30) Priority: 22.04.2003 JP 2003117081
(71) Applicant: ALPS ELECTRIC CO., LTD., Tokyo 145-8501 (JP)
(72) Inventor: Suzuki, Shigetaka, Ota-ku Tokyo 145-8501 (JP)
(74) Representative: Klunker . Schmitt-Nilson . Hirsch

(57) **Abstract**

A transistor oscillator is provided which is suitable to miniaturization and has little Q deterioration. By using the transistor 1 having a frequency of gain bandwidth product of 15 GHz or more and a cylindrical dielectric resonator 4 having a relative dielectric constant of 70 or more, the dielectric resonator 4 is bonded and fixed between a pair of linear microstrip lines 2 and 3, which are formed parallel to each other on a circuit board 7, and the base B and the collector C of the transistor 1 are connected to the ends of the microstrip lines 2 and 3. Through the layout, a high frequency coupling can be made between the parts of the microstrip lines 2 and 3 and the dielectric resonator 4, thereby preventing Q deterioration from being generated. In addition, since the size of the dielectric resonator 4 and the area occupied by the microstrip lines 2 and 3 can be reduced, it is possible to miniaturize the transistor oscillator.

## Description

### BACKGROUND OF THE INVENTION

### 1. Field of the Invention

The present invention relates to a transistor oscillator employed in a local oscillator of a converter for receiving a satellite broadcasting and more particularly, to a feedback type transistor oscillator in which signals transmitted from a signal output terminal of a transistor are introduced to a signal input terminal thereof via a dielectric resonator.

### 2. Description of the Related Art

Recently, in a converter for receiving a satellite broadcast, which uses Ku band, a frequency band of the local oscillation signals has been increased up to 10 GHz to 12 GHz and a transistor having a high Ft frequency (frequency of gain band width product) has been used as an oscillation element of a local oscillation circuit along with a high frequency band.

A conventional transistor oscillator has been proposed in which a transistor having an Ft frequency of 30 GHz or more is used as an oscillation element, microstrip lines are connected to the signal input and output terminals of the transistor, respectively, and a cylindrical dielectric resonator is placed between and connected to the microstrip lines with a high frequency (for example, see Patent Document 1). Herein, a base terminal of the transistor is connected to an end of one microstrip line, a collector terminal of the transistor is connected to an end of the other microstrip line, and an emitter terminal of the transistor is grounded.

In the transistor oscillator generally configured as described above, signals of levels of thermal noise exists in the dielectric resonator. Since the thermal noise repeats interferential reflection in the circumferential surface of the dielectric resonator, the dielectric resonator resonates at a specific frequency. The signals generated due to the resonance are introduced to a base terminal of the transistor via a high frequency coupling between the dielectric resonator and one microstrip line, and then the signals introduced to the base terminal of the transistor are amplified by the transistor and are introduced to the other microstrip line. In addition, the signals introduced to the other microstrip line invade the dielectric resonator via a high frequency coupling between the other microstrip line and the dielectric resonator. In addition, only a signal of a specific (resonance) frequency by the dielectric resonator is enhanced and is applied to the base terminal of the transistor. That is, a feedback type transistor oscillator is configured with the dielectric resonator inserted in the output path of signals from the collector terminal of the transistor to the base terminal of the transistor. As a result, oscillation signals equivalent to the resonance frequency of the dielectric resonator occur in the collector terminal of the transistor.

### [Patent Document 1]

Japanese Unexamined Patent Application Publication No. 2001-217648 (Pages 4 and 5 and Fig. 1)

Although the aforementioned Patent Document 1 does not disclose a specific configuration including the size of the dielectric resonator and a mounting structure thereof, the dielectric resonator having a relative dielectric constant εᵣ of about 30 to 40 is used, and a mounting structure in which the dielectric resonator is fixed to the circuit board via a dielectric spacer, is adopted. In this case, the diameter of the dielectric resonator is about 5 mm and is much larger than the transistor. As a result, a pair of microstrip lines is located in an truncated inverted chevron shape via the dielectric resonator and the base terminal and the collector terminal of the transistor are soldered to the adjacent ends of the two microstrip lines.

However, in a layout where the microstrip lines are located on both sides of the dielectric resonator in a truncated inverted chevron shape, there is a problem in that an excessive high frequency coupling occurs between the microstrip lines and the dielectric resonator tends to generate Q deterioration. In addition, the size of the transistor oscillator increases due to the open ends of the two-microstrip lines, which expand in a truncated inverted chevron shape. In addition, since the electric resonator is fixed to the circuit board via the dielectric spacer, the height of the transistor oscillator increases due to the existence of the dielectric spacer, thereby preventing miniaturization of the transistor oscillator.

### SUMMARY OF THE INVENTION

The present invention had been made in consideration of the above problem. It is therefore an object of the present invention to provide a transistor oscillator, which is suitable to miniaturization and has little Q deterioration.

In order to achieve the above object, a transistor oscillator according to the present invention includes a circuit board having a pair of linear microstrip lines formed thereon, the pair of microstrip lines being opposed substantially parallel to each other; a transistor mounted on the circuit board and having a frequency of gain bandwidth product of 15 GHz or more; and a cylindrical dielectric resonator located between the pair of microstrip lines and having a relative dielectric constant of 70 or more, wherein a signal input terminal of the transistor is connected to the end of the one microstrip line, a signal output terminal of the transistor is connected to the end of the other microstrip line, and the bottom surface of the cylindrical dielectric resonator is boned to the circuit board.

By using the transistor having a frequency of gain bandwidth product of 15 GHz or more and a cylindrical dielectric resonator having a relative dielectric constant of 70 or more in the aforementioned transistor oscillator, it is possible to implement an ideal layout that a pair of microstrip lines, which extend linearly on both sides of the dielectric resonator, are located substantially parallel to each other. As a result, a high frequency coupling can be made between the parts of the microstrip lines and the dielectric resonator, thereby preventing Q deterioration from being generated. In addition, the dielectric resonator with a small diameter is bonded and fixed to the circuit board and the microstrip lines are placed substantially parallel to each other on both sides of the dielectric resonator. As a result, the height and size of the transistor oscillator may be small, which allows for the miniaturization of the transistor oscillator.

In the above configuration, the dielectric resonator is preferably set so that the diameter is 2.5 mm to 3.5 mm and the height is less than 2.0 mm. In addition, the microstrip lines are preferably set so that their lengths are a half of an oscillatory frequency or a quarter of the wavelength of the oscillatory frequency.

### BRIEF DESCRIPTION OF THE DRAWINGS

Fig. 1 is a plan view illustrating essential parts of a transistor oscillator according to a first embodiment of the present invention;
Fig. 2 is a sectional view of the transistor oscillator; and
Fig. 3 is an equivalent circuit diagram of the transistor oscillator.

### DESCRIPTION OF THE PREFERRED EMBODIMENTS

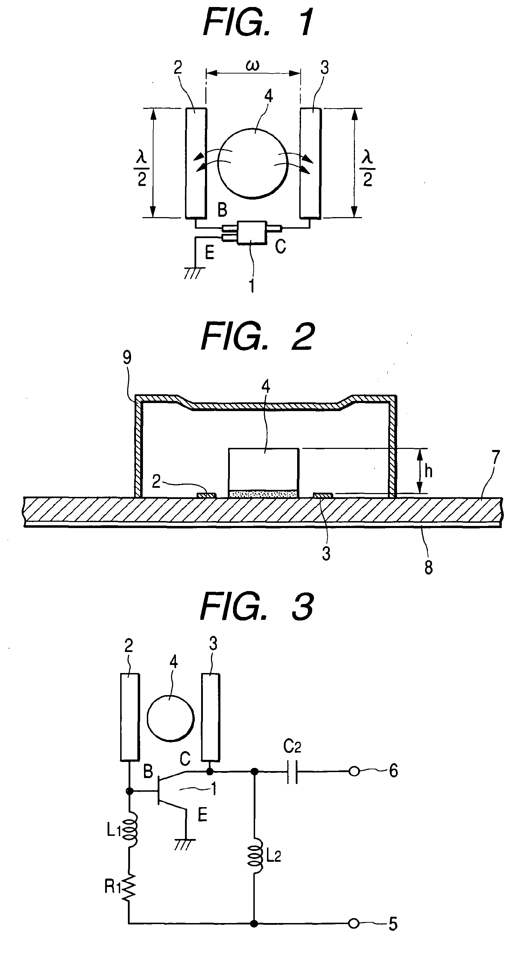

Hereinafter, embodiments of the present invention will be described with reference to the accompanying drawings. Fig. 1 is a plan view illustrating essential parts of a transistor oscillator according to an embodiment of the present invention. Fig. 2 is a sectional view of the transistor oscillator. Fig. 3 is an equivalent circuit diagram of the transistor oscillator.

The transistor oscillator according to this embodiment is, for example, applied to a circuit of a converter for receiving a satellite broadcast. As shown in Fig. 3, the transistor oscillator comprises a transistor 1, a pair of microstrip lines 2 and 3, and a dielectric oscillator 4. The transistor 1 is a silicon transistor with an Ft frequency thereof (frequency of gain bandwidth product) of 15 GHz or more. The rear ends of the microstrip lines 2 and 3 are connected to the base B and collector C of the transistor 1. The front ends of the microstrip lines 2 and 3 are open and the lengths thereof are set to about a half of the wavelength of the resonance frequency of the transistor oscillator. A power terminal 5 is connected to the base B of the transistor 1 via a bias resistor R₁ and a choke coil L₁, and the emitter E of the transistor 1 is grounded. In addition, the power terminal 5 is connected to the collector C of the transistor 1 via a coil L₂ and the output is led from an output terminal 6 via a direct current cut capacitor C₂. A dielectric resonator 4 has a cylindrical body made of a dielectric material having a relative dielectric constant εᵣ of 70 or more and is located between the two microstrip lines 2 and 3. In this embodiment, the dielectric resonator 4 made of a ceramic material having εᵣ=90 is used and the diameter thereof is set to 2.0 mm and the height is set to 1.7 mm.

As shown in Figs. 1 and 2, a ground pattern 8 is formed in an entire bottom surface of a circuit board 7. In addition, the microstrip lines 2 and 3 of the circuit components of the transistor oscillator are linearly patterned on the circuit board 7 such that they are opposed substantially parallel to each other. In addition, the transistor 1 and the dielectric resonator 4 are bonded and fixed to the circuit board 7, and the base B and the collector C of the transistor 1 are soldered to the rear ends of the microstrip lines 2 and 3. The dielectric resonator 4 is positioned between the microstrip lines 2 and 3. In addition, although not shown, a wiring pattern is formed on the circuit board 7. In addition, all of other circuit components such as a bias resistor R₁, coils L₁ and L₂, and a capacitor C₂ are soldered to the land portion of the wiring pattern as chip components. In addition, the circuit components of the transistor oscillator are covered with an OSC cover 9, which is soldered to the circuit board 7. As shown in Fig. 2, the upper portion of the OSC cover 9 is deformed with pressure so that a gap between the dielectric resonator 4 and the OSC cover 9 can be changed, thereby minutely adjusting the oscillatory frequency.

In the transistor oscillator having the above configuration, signals of levels of thermal noise exist in the dielectric resonator 4. Since the thermal noise signals repeat interferential reflection in the circumferential surface of the dielectric resonator 4, the dielectric resonator 4 resonates at a specific frequency. The signals generated due to the resonance are introduced to the base B of the transistor 1 via a high frequency coupling between the dielectric resonator 4 and the microstrip line 2 and then the signals introduced to the base B of the transistor 1 are amplified by the transistor 1 and are introduced to the microstrip line 3. In addition, the signals introduced to the microstrip line 3 invade the dielectric resonator 4 via a high frequency coupling between the microstrip line 3 and the dielectric resonator 4. In addition, only a signal component of a specific (resonance) frequency by a resonance operation of the dielectric resonator 4 is enhanced and is applied to the base B of the transistor 1 via the microstrip line 2. That is, a feedback type transistor oscillator is configured with the dielectric resonator 4 inserted in a path where signals transmitted from the collector terminal C of the transistor 1 are introduced to the base B. As a result, oscillation signals of the frequency equivalent to the resonance frequency of the dielectric resonator 4 occur in the collector C of the transistor 1.

According to the transistor oscillator related to this embodiment, used are the transistor 1 having an Ft frequency (frequency of gain bandwidth product) of 15 GHz or more and a cylindrical dielectric resonator 4 having a relative dielectric constant of 70 or more (εᵣ=90). As a result, it is possible to attain an ideal layout such that the base B and the collector C of the transistor 1 are connected to the ends of a pair of linear microstrip lines 2 and 3 which are opposed substantially parallel to each other on the circuit board 7 and the dielectric resonator 4 is located between the microstrip lines 2 and 3. Accordingly, as indicated by an arrow in Fig. 1, a high frequency coupling can made between parts of the microstrip line 2 and 3 and the dielectric resonator 4, thereby suppressing Q deterioration from excessive coupling. In addition, the dielectric resonator 4, which is bonded and fixed to the circuit board 7, is small with a height (h) of about 1.7 mm and a diameter (w) of about 2.0 mm. As a result, the height and size of the transistor oscillator can be reduced to achieve miniaturization.

In addition, in the embodiments, although a case of setting the lengths of the microstrip lines 2 and 3 to a half of the wavelength of a resonance frequency of the oscillator has been described, the lengths of the microstrip lines 2 and 3 may be set to a quarter of the wavelength of a resonance frequency of the oscillator. In addition, the relative dielectric constant εᵣ, the diameter and the height of the dielectric resonator 4 are not limited to that of the embodiment, but it may be set such that the relative dielectric constant of the dielectric resonator is 70 or more, the diameter of the dielectric resonator is 2.5 to 3.5 mm, and the height of the dielectric resonator is 2.0 mm or less.

The present invention is carried out according to the embodiments described above, and the following effects can be obtained.

By using the transistor having a frequency of gain bandwidth product of 15 GHz or more and a cylindrical dielectric resonator having a relative dielectric constant of 70 or more, it is possible to implement an ideal layout such that a pair of microstrip lines, which extend linearly on both sides of the dielectric resonator, is located substantially parallel to each other. As a result, a high frequency coupling can be made between the parts of the microstrip lines and the dielectric resonator, thereby preventing Q deterioration from being generated. In addition, the dielectric resonator having a small diameter is bonded and fixed to the circuit board and the microstrip lines are placed substantially parallel to each other on both sides of the dielectric resonator. As a result, the height and size of the transistor oscillator can be reduced to achieve miniaturization of the transistor oscillator.

## Claims

1. A transistor oscillator comprising:
a circuit board having a pair of linear microstrip lines formed thereon, wherein the pair of microstrip lines is opposed substantially parallel to each other;
a transistor mounted on the circuit board having a frequency of gain bandwidth product of 15 GHz or more; and
a cylindrical dielectric resonator placed between the pair of microstrip lines and having a relative dielectric constant of 70 or more,
wherein a signal input terminal of the transistor is connected to the end of the one microstrip line, a signal output terminal of the transistor is connected to the end of the other microstrip line, and the bottom surface of the cylindrical dielectric resonator is boned to the circuit board.

2. The transistor oscillator according to Claim 1,
wherein the dielectric resonator is set such that the diameter is 2.5 mm to 3.5 mm and the height is 2.0 mm or less.

3. The transistor oscillator according to Claim 1 or 2,
wherein the pair of microstrip lines are set such that the lengths are a half of an oscillatory frequency or a quarter of the wavelength of an oscillator frequency.
